# EUROPEAN PATENT APPLICATION

(11) **EP 4 711 742 A1**
(43) Date of publication of application: **18.03.2026**
(21) Application number: 25198781.4
(22) Date of filing: 28.08.2025
(51) Int. Cl.: G01N 3/62

(54) **MANAGEMENT OF DISTRIBUTED MATERIAL TESTING SYSTEMS**

(30) Priority: 16.09.2024 US 202463695085 P; 26.08.2025 US 202519310158
(71) Applicant: Illinois Tool Works Inc., Glenview IL 60025 (US)
(72) Inventor: CAESAR, Daniel Vincent, Glenview, 60025 (US); NICOL, Scott, Glenview, 60025 (US); MORSE, Jason, Glenview, 60025 (US)
(74) Representative: HGF

(57) **Abstract**

Described herein are examples of distributed material testing systems that collect data from a plurality of material testing systems. In some examples, a central management server is used to collect the data and identify status information, statistical metrics, and/or historical events pertaining to selected material testing systems based on the collected data. In some examples, because the central management server is used, the status information, statistical metrics, and/or historical events can be accessed through any interface in communication with the central management server. In some examples, the status information, statistical metrics, and/or historical events may be used by managers and/or administrators to monitor testing activities, identify and/or address issues, and/or plan for future tests.

## Description

### CROSS REFERENCE TO RELATED APPLICATIONS

This application claims priority to, and the benefit of, U.S. Provisional Patent Application No. 63/695,085, filed September 16, 2024, entitled "MANAGEMENT OF DISTRIBUTED MATERIAL TESTING SYSTEMS," the entire contents of which are hereby incorporated by reference.

### TECHNICAL FIELD

The present disclosure generally relates to distributed material testing systems and, more particularly, to management of distributed material testing systems.

### BACKGROUND

Material testing machines are used to test the properties (e.g., tensile/compressive strength) of various material specimens. The particular method of testing (a.k.a. test method) may vary from material specimen to material specimen and/or material testing machine to material testing machine.

Limitations and disadvantages of conventional and traditional approaches will become apparent to one of skill in the art, through comparison of such systems with the present disclosure as set forth in the remainder of the present application with reference to the drawings.

### BRIEF SUMMARY

The present disclosure is directed to management of distributed material testing systems, substantially as illustrated by and/or described in connection with at least one of the figures, and as set forth more completely in the claims.

These and other advantages, aspects and novel features of the present disclosure, as well as details of an illustrated example thereof, will be more fully understood from the following description and drawings.

### BRIEF DESCRIPTION OF THE DRAWINGS

FIG. 1 shows an example material testing system, in accordance with aspects of this disclosure.
FIG. 2 shows a block diagram of the example material testing system of FIG. 1, in accordance with aspects of this disclosure.
FIG. 3 shows a block diagram of an example distributed material testing system, in accordance with aspects of this disclosure.
FIG. 4 shows a flowchart illustrating an example central management process of the distributed material testing system of FIG. 3, in accordance with aspects of this disclosure.
FIGS. 5a-5g are examples of graphical user interfaces (GUIs) that might be shown during the central management process of FIG. 4, in accordance with aspects of this disclosure.

The figures are not necessarily to scale. Where appropriate, the same or similar reference numerals are used in the figures to refer to similar or identical elements. For example, reference numerals utilizing lettering (e.g., grip 124a, grip 124b) refer to instances of the same reference numeral that does not have the lettering (e.g., grips 124).

### DETAILED DESCRIPTION

Disclosed herein are examples of distributed material testing systems that use a central management server to collect data from several material testing system in communication with the central management server. In some examples, the central management server is configured to identify relevant system management information using the collected data, and allow users to access the system management information from any workstation, terminal, and/or other user interface connected to the central management server. In some examples, the system management information may enable users to easily compare and/or contrast the operational efficiency and/or utilization of different material testing systems. The system management information may additionally be helpful for auditing, monitoring testing activities, identifying and/or addressing issues, and/or planning for future tests.

Some examples of the present disclosure relate to a non-transitory computer readable medium comprising machine readable instructions which, when executed by processing circuitry, cause the processing circuitry to: receive test data from one or more material testing systems, the test data relating to testers, test parameters, test results, or test timings of a plurality of tests conducted using the one or more material testing systems; determine a utilization metric based on the test data, the utilization metric indicating how much or how often a particular material testing system, or the one or more of material testing systems were used during a selected time period; output, via a user interface, a human perceptible representation of the utilization metric.

In some examples, the utilization metric comprises (i) a number of tests performed by one or more testers, the particular material testing system, or the one or more material testing systems, during the selected time period, (ii) an amount of samples or specimens tested by the one or more testers, the particular material testing system, or the one or more material testing systems, during the selected time period, or (iii) a fraction or percentage of the one or more testers, or the one or more material testing systems, that were performing a test at particular times during the selected time period.

In some examples, the human perceptible representation comprises a first human perceptible representation, and the non-transitory computer readable medium further comprises machine readable instructions which, when executed by the processing circuitry, cause the processing circuitry to: receive system data from the one or more material testing systems, the system data pertaining to information about the one or more material testing systems; identify the particular material testing system based on a user selection received via the user interface; determine particular system data relevant to the particular material testing system based on the system data, the test data, and the particular material testing system; and output, via the user interface, a second human perceptible representation of the particular system data.

In some examples, the particular system data comprises a system identifier of the particular material testing system, a current testing status of the particular material testing system, a current tester of the particular material testing system, event information relating to one or more events pertaining to the particular material testing system, a machine identifier of a particular material testing machine of the particular material testing system, a date of manufacture of the particular material testing machine, a description of the particular material testing machine, sensor information relating to one or more sensors of the particular material testing machine, calibration information relating to a calibration of the one or more sensors or the particular material testing machine, a workstation identifier of a particular testing workstation of the particular material testing system, or software information relating to a software running on the particular testing workstation.

In some examples, the non-transitory computer readable medium further comprises machine readable instructions which, when executed by the processing circuitry, cause the processing circuitry to: receive system data from a particular material testing system of the one or more material testing systems, the system data comprising error data indicating that a sensor or other machine component of a particular material testing machine of the particular material testing system has had a malfunction; determine, based on the error data, whether the malfunction warrants servicing of the sensor or the particular material testing machine; in response to determining the malfunction does warrant servicing of the sensor or the particular material testing machine, output a query, via the user interface, as to whether a service visit should be scheduled; and in response to receiving a positive response to the query, communicate with a service center, via the central server, to schedule the service visit.

In some examples, the non-transitory computer readable medium further comprises machine readable instructions which, when executed by the processing circuitry, cause the processing circuitry to: identify one or more qualified service technicians based on the malfunction, the error data, the type of sensor or other machine component, the test data, or a service history; and outputting, via the user interface, a list identifying the one or more qualified service technicians. In some examples, the non-transitory computer readable medium further comprises machine readable instructions which, when executed by the processing circuitry, cause the processing circuitry to communicate with the service center to schedule the service visit in response to receiving, via the user interface, a selection of a particular service technician and identifying the service center of the particular service technician.

Some examples of the present disclosure relate to a system, comprising: one or more material testing systems configured to conduct a plurality of tests on a plurality of material specimens, and transmit test data relating to testers, test parameters, test results, or test timings of the plurality of tests; a central server configured to receive the test data from the one or more material testing systems, the central server comprising central server processing circuitry configured to determine a utilization metric based on the test data, the utilization metric indicating how much or how often a particular material testing system, or the plurality of material testing systems were used during a selected time period; a user interface in communication with the central server, the user interface being configured to output a human perceptible representation of the utilization metric.

In some examples, the utilization metric comprises (i) a number of tests performed during the selected time period by one or more testers, the particular material testing system, or the one or more material testing systems, (ii) an amount of samples or specimens tested during the selected time period by the one or more testers, the particular material testing system, or the one or more material testing systems, or (iii) a fraction or percentage of the one or more testers, or the one or more material testing systems, that were preparing, performing, or analyzing results of a test at particular times during the selected time period.

In some examples, the human perceptible representation comprises a first human perceptible representation, the one or more material testing systems are further configured to send system data to the central server, the system data pertaining to information about the one or more material testing systems, the central server processing circuitry is further configured to identify the particular material testing system based on a user selection, and determine particular system data relevant to the particular material testing system based on the system data, the test data, and the particular material testing system, and the user interface is configured to receive the user selection as an input, and output a second human perceptible representation of the particular system data.

In some examples, the particular system data comprises a system identifier of the particular material testing system, a current testing status of the particular material testing system, a current tester of the particular material testing system, event information relating to one or more events pertaining to the particular material testing system, a machine identifier of a particular material testing machine of the particular material testing system, a date of manufacture of the particular material testing machine, a description of the particular material testing machine, sensor information relating to one or more sensors of the particular material testing machine, calibration information relating to a calibration of the one or more sensors or the particular material testing machine, a workstation identifier of a particular testing workstation of the particular material testing system, or software information relating to a software running on the particular testing workstation.

In some examples, the plurality of material testing systems are further configured to send system data to the central server, the system data comprising error data indicating that a sensor or other machine component of a particular material testing machine of the particular material testing system has had a malfunction, and the central server processing circuitry is further configured to: determine, based on the error data, whether the malfunction warrants servicing of the sensor or the particular material testing machine, in response to determining the malfunction does warrant servicing of the sensor or the particular material testing machine, output a query, via the user interface, as to whether a service visit should be scheduled, and in response to receiving a positive response to the query, via the user interface, communicate with a service center to schedule the service visit.

In some examples, the central server processing circuitry is further configured to: identify one or more qualified service technicians based on the malfunction, the error data, the type of sensor or other machine component, the test data, or a service history, and output, via the user interface, a list identifying the one or more qualified service technicians. In some examples, the user interface is configured to receive a selection of a particular service technician from the list identifying the one or more qualified service technicians, the central server processing circuitry is configured to identify the service center of the particular service technician, and the central server is configured to communicate with the service center to schedule the service visit.

Some examples of the present disclosure relate to a method, comprising: receiving, at a central server, test data from one or more material testing systems, the test data relating to testers, test parameters, test results, or test timings of a plurality of tests conducted using the one or more material testing systems; determining, at the central server, a utilization metric based on the test data, the utilization metric indicating how much or how often a particular material testing system, or the one or more material testing systems were used for testing during a selected time period; and outputting, via a user interface, a human perceptible representation of the utilization metric.

In some examples, the utilization metric comprises (i) a number of tests performed by one or more testers, the particular material testing system, or the one or more material testing systems, during the selected time period, (ii) an amount of samples or specimens tested by the one or more testers, the particular material testing system, or the one or more material testing systems, during the selected time period, or (iii) a fraction or percentage of the one or more testers, or the one or more material testing systems, that were performing a test at particular times during the selected time period.

In some examples, the human perceptible representation comprises a first human perceptible representation, the method further comprising: receiving, at the central server, system data from the one or more material testing systems, the system data pertaining to information about the one or more material testing systems; identifying, via the central server, the particular material testing system based on a user selection received via the user interface; determining particular system data relevant to the particular material testing system based on the system data, the test data, and the particular material testing system; and outputting, via the user interface, a second human perceptible representation of the particular system data.

In some examples, the particular system data comprises a system identifier of the particular material testing system, a current testing status of the particular material testing system, a current tester of the particular material testing system, event information relating to one or more events pertaining to the particular material testing system, a machine identifier of a particular material testing machine of the particular material testing system, a date of manufacture of the particular material testing machine, a description of the particular material testing machine, sensor information relating to one or more sensors of the particular material testing machine, calibration information relating to a calibration of the one or more sensors or the particular material testing machine, a workstation identifier of a particular testing workstation of the particular material testing system, or software information relating to a software running on the particular testing workstation.

In some examples, the method further comprises receiving, at the central server, system data from a particular material testing system of the one or more material testing systems, the system data comprising error data indicating that a sensor or other machine component of a particular material testing machine of the particular material testing system has had a malfunction; determining, via the central server, based on the error data, whether the malfunction warrants servicing of the sensor or the particular material testing machine; in response to determining the malfunction does warrant servicing of the sensor or the particular material testing machine, outputting a query, via the user interface, as to whether a service visit should be scheduled; and in response to receiving a positive response to the query, communicating with a service center, via the central server, to schedule the service visit.

In some examples, the method further comprises identifying one or more qualified service technicians based on the malfunction, the error data, the type of sensor or other machine component, the test data, or a service history; and outputting, via the user interface, a list identifying the one or more qualified service technicians, wherein the central server communicates with the service center to schedule the service visit in response to receiving, via the user interface, a selection of a particular service technician and identifying the service center of the particular service technician.

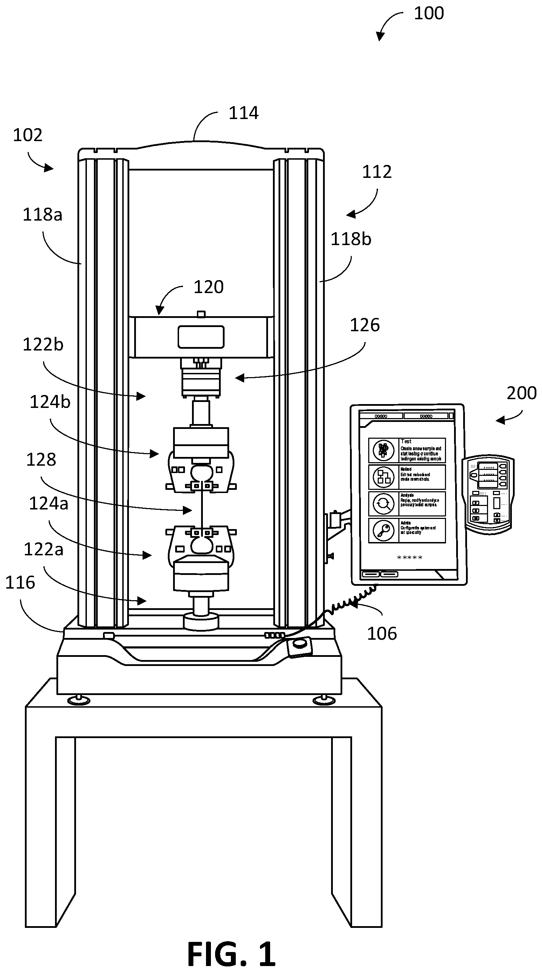

FIG. 1 shows an example material testing system 100. As shown, the material testing system 100 includes a material testing machine 102 (also known as a universal testing machine), and a computing system 200 connected to the material testing machine 102 through cable 106. While shown as being physically connected, in some examples, the connections may be wireless rather than wired.

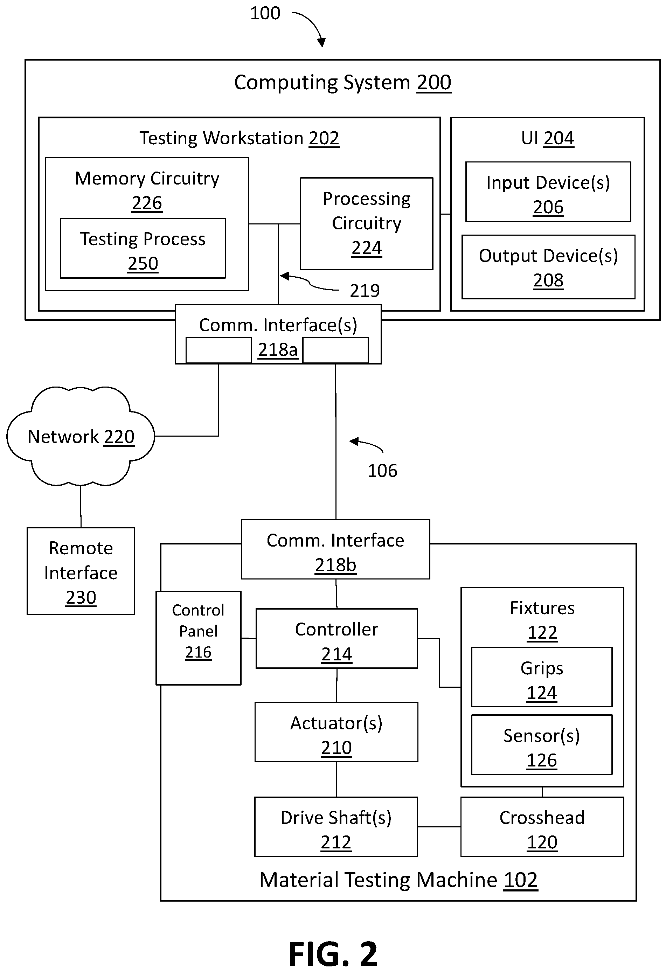

In the example of FIG. 1, the material testing machine 102 includes a frame 112. In some examples, the frame 112 provides rigid structural support for the other components of the material testing machine 102. As shown, the frame 112 comprises a top plate 114 and a bottom base 116 connected by two columns 118. In some examples, the columns 118 of the frame 112 may house guide rails and/or drive shafts 212 of the material testing machine 102 (see, e.g., FIG. 2).

In the example of FIG. 1, a movable crosshead 120 extends between the columns 118. In some examples, the movable crosshead 120 may be connected to the guide rails and/or drive shafts 212 housed in the columns 118, and/or configured to move toward and/or away from the base 116 through (e.g., motorized) actuation of the drive shaft(s) 212. While one movable crosshead 120 is shown in the example of FIG. 1, in some examples, the material testing machine 102 may have multiple movable crossheads 120, and/or other movable members.

In the example of FIG. 1, a fixture 122 is attached to the bottom base 116 of the frame 112, as well as to the movable crosshead 120. As shown, the lower fixture 122a includes a grip 124a, while the upper fixture 122b includes both a test sensor 126 and a grip 124b. While one test sensor 126 and two grips 124 are shown in the example of FIG. 1, in some examples, the testing machine 102 may include more or fewer test sensors 126 and/or grips 124.

In the example of FIG. 1, the grips 124 are holding a test specimen 128. While shown as a (e.g., steel) rope/wire, in some examples, the test specimen 128 may be some other type of material and/or component. While shown as being rope holders, in some examples, the grip 124a and/or grip 124b may alternatively, or additionally, be configured as a bolt holder, wedge grip, side acting grip, manual grip, roller grip, capstan grip, and/or syringe holder. In some examples, one or both of the grips 124 may be replaced by a compression platen configured to compress the test specimen 128.

In the example of FIG. 1, the test sensor 126 is connected to the grip 124, such that the test sensor 126 can measure forces acting on the grip 124 (and/or specimen 128, crosshead 120, etc.). In some examples, the test sensor 126 may be a load cell. In some examples, the test sensor 126 may be some other type of sensor.

In some examples, the material testing machine 102 may be configured for static mechanical testing. For example, the material testing machine 102 may be configured for compression strength testing, tension strength testing, shear strength testing, bend strength testing, deflection strength testing, tearing strength testing, peel strength testing (e.g., strength of an adhesive bond), torsional strength testing, and/or any other compressive and/or tensile testing. Additionally or alternatively, the material testing machine 102 may be configured to perform dynamic testing.

In some examples, the material testing machine 102 is configured to interface with the computing system 200 to conduct a test method. For example, the computing system 200 may communicate with a controller 214 (see, e.g., FIG. 2) of the material testing machine 102 to conduct the test method.

FIG. 2 is a block diagram showing details of the computing system 200, as well as additional details of the material testing machine 102. In the example of FIG. 2, the example material testing machine 102 includes one or more actuators 210 connected with one or more drive shafts 212. In some examples, the actuators 210 may be used to provide force to, and/or induce motion of, the drive shafts 212. In some examples, the actuators 210 may include electric motors, pneumatic actuators, hydraulic actuators, piezoelectric actuators, relays, and/or switches.

The drive shafts 212 are further shown connected to the movable crosshead 120, such that movement of the drive shaft(s) 212 via the actuator(s) 210 will result in movement of the movable crosshead 120. While termed drive shafts 212 in the example of FIG. 2, in some examples, the drive shafts 212 may be some other mechanical means of moving the movable crosshead 120 though inducement by the actuator(s) 210.

The example material testing machine 102 further includes a controller 214 in electrical communication with the actuator(s) 210. In some examples, the controller 214 may include processing circuitry and/or memory circuitry. In some examples, the controller 214 may be configured to control the material testing machine 102 based on one or more commands, control inputs, and/or test parameters. In some examples, the controller 214 may be configured to translate commands, control inputs, and/or test parameters (e.g., received from the computing system 200) to appropriate (e.g., electrical) signals that may be delivered to the actuator(s) 210, thereby controlling operation of the material testing machine 102 (e.g., via the actuator(s) 210). For example, the controller 214 may provide one or more signals(s) commanding more or less electrical power be provided to the actuator(s) 210, to thereby increase or decrease applied force.

In the example of FIG. 2, the controller 214 is further in electrical communication with the fixtures 122 (e.g., the grips 124 and test sensor(s) 126). In some examples, the controller 214 may be configured to translate commands, control inputs, and/or test parameters (e.g., received from the computing system 200) to appropriate (e.g., electrical) signals that may be delivered to the grips 124, to thereby control (e.g., grip or release) operation of the grips 124. In some examples, the controller 214 may be configured to translate commands, control inputs, and/or parameters (e.g., received from the computing system 200) to appropriate (e.g., electrical) signals that may be delivered to the sensor(s) 126, to thereby control operation of the sensor(s) 126. In some examples, the controller 214 may be configured to translate measurement data received from the sensor(s) 126, and/or send measurement data to the computing system 200.

The example controller 214 is further in electrical communication with a control panel 216 of the material testing machine 102. In some examples, the control panel 216 may include one or more input devices (e.g., buttons, switches, slides, knobs, microphones, dials, and/or other electromechanical input devices). In some examples, the control panel 216 may be used by an operator to directly control the material testing machine 102. In some examples, the controller 214 may be configured to translate commands, control inputs, and/or test parameters received via the control panel 216 to appropriate (e.g., electrical) signals that may be delivered to the actuator(s) 210 and/or grip(s) 124 to control the material testing machine 102.

The controller 214 is also shown in electrical communication with a communication interface 218b of the material testing machine 102. In some examples, the communication interface 218b comprises a network interface. In some examples, the communication interface 218b includes hardware, firmware, and/or software to connect the material testing machine 102 to a complementary workstation communication interface 218a of the computing system 200. In some examples, the controller 214 may receive information (e.g., commands) from the computing system 200 through the communication interfaces 218, and/or send information (e.g., measurement data from sensor(s) 126) to the computing system 200 through the workstation communication interfaces 218.

In the example of FIG. 2, the computing system 200 includes a testing workstation 202 and a user interface (UI) 204 interconnected with one another. As shown, the **UI** 204 may include one or more input devices 206 configured to receive inputs from a user, and one or more output devices 208 configured to provide outputs to the user.

In some examples, the one or more input devices 206 may comprise one or more touch screens, mice, keyboards, buttons, switches, slides, knobs, microphones, dials, and/or other input devices 206. In some examples, the one or more output devices 208 may comprise one or more display/touch screens, speakers, lights, haptic devices, and/or other output devices 208. In some examples, the output device(s) 208 (e.g., a display screen) of the UI 204 may output one or more representations of a material testing process 250 configured to allow a user to setup and/or execute a test method and/or analyze test results of the test method. In some examples, the input device(s) 206 of the UI 204 may receive input from a user, and send input data representative of the user input to the testing workstation 202.

In the example of FIG. 2, the example testing workstation 202 includes workstation communication interfaces 218a. In some examples, one or more of the workstation communication interfaces 218a are network interfaces. In some examples, one or more of the workstation communication interfaces 218a comprise hardware, firmware, and/or software configured to facilitate communication between the workstation 202 and one or more external networks, servers, systems, and/or devices.

As shown, one workstation communication interface 218a is in communication with the communication interface 218b of the material testing machine 102 through cable 106. As shown, the testing workstation 202 further includes a workstation communication interface 218a in communication with a network 220 (e.g., the Internet). In the example of FIG. 2, the testing workstation 202 is in communication with a remote interface 230 through the network 220 and workstation communication interface 218a. In some examples, the testing workstation 202 may be in communication with one or more other testing systems, servers, and/or other devices through the network and/or workstation communication interface(s) 218a. As shown, the workstation communication interfaces 218a are electrically connected to a common electrical bus 219 of the testing workstation 202.

In some examples, the testing workstation 202 may be a computing device. In the example of FIG. 2, the testing workstation 202 includes workstation processing circuitry 224 connected to the common electrical bus 219. In some examples, the workstation processing circuitry 224 may comprise one or more processors. In some examples, the workstation processing circuitry 224 is configured to process information received from the UI 204, data importation device(s) 108, and/or material testing machine 102.

In some examples, the workstation processing circuitry 224 is configured to transmit (e.g., via communication interface(s) 218a) commands and/or test parameters to the material testing machine 102. In some examples, the workstation processing circuitry 224 is configured to output information to an operator through the UI 204. In some examples, the workstation processing circuitry 224 is configured to execute machine readable instructions stored in workstation memory circuitry 226.

In the example of FIG. 2, the testing workstation 202 further includes workstation memory circuitry 226 connected to the common electrical bus 219. As shown, the workstation memory circuitry 226 includes a material testing process 250. In some examples, the material testing process 250 comprises machine readable instructions. In some examples, the workstation processing circuitry 224 is configured to execute the machine readable instructions of the material testing process 250 to communicate with (e.g., the controller 214 of) the material testing machine 102 to setup a test of a material specimen 128, perform the test of the material specimen 128, and/or analyze test results of the test of the material specimen 128.

In some examples, a user sets up a test of a material specimen 128 by specifying (e.g., using the UI 204) certain parameters of the test, material specimen 128, and/or test result analysis. In some examples, test parameters may include a date the test will be run, identification information of the test (e.g., number, name, type, description, etc.), target start/end positions of grip(s) 124, target start/end positions of the crosshead 120, target distance/direction moved by crosshead 120, target speed of movement of crosshead 120, expected result(s) of test (e.g., position/type of break, distance moved before break, force applied before break, post-test characteristics of sample, etc.), time(s) when sensor(s) 126 should take measurement(s), and/or other information relevant to a particular test method.

In some examples, specimen parameters may include, a date the specimen 128 was manufactured/shipped/packaged, identification information of the specimen 128 (e.g., number, name, description, etc.), pre-test characteristics of the specimen 128 (e.g., measurements/dimensions, material type, weight, color, shape, modulus, ultimate tensile strength, etc.), and/or other information relevant to a particular specimen 128. In some examples, analysis parameters may include one or more algorithms that may be used to evaluate results of the test method (and/or produce additional test results), one or more test result report format(s), and/or one or more thresholds and/or threshold ranges (e.g., by which test results may be adjudged to determine whether the specimen 128 passed or failed the test).

In some examples, some or all of the specimen, test, and/or analysis parameters are saved in (and/or specified by) a test file (e.g., saved in workstation memory circuitry 226 and/or other memory circuitry). In some examples, the specimen, test, and/or analysis parameters are used by the testing workstation 202 when executing the material testing process 250, performing the test of the material specimen 128, and/or analyzing test results of the test of the material specimen 128.

In some examples, the material testing system 100 is considered to be "utilized" for testing (and/or in a test state) when a user uses the testing workstation 202 (and/or material testing machine 102) to setup a test of a material specimen 128, perform the test of the material specimen 128, and/or analyze test results of the test of the material specimen 128. In some examples, the utilization and/or test state status of the material testing system 100 may be relevant when identifying statistical metrics and/or other information used for management of material testing systems 100. In some examples, data representative of the utilization, test state status, and/or other information pertaining to the material testing system 100 is transmitted to a central management server 302 that is in communication with the material testing system 100.

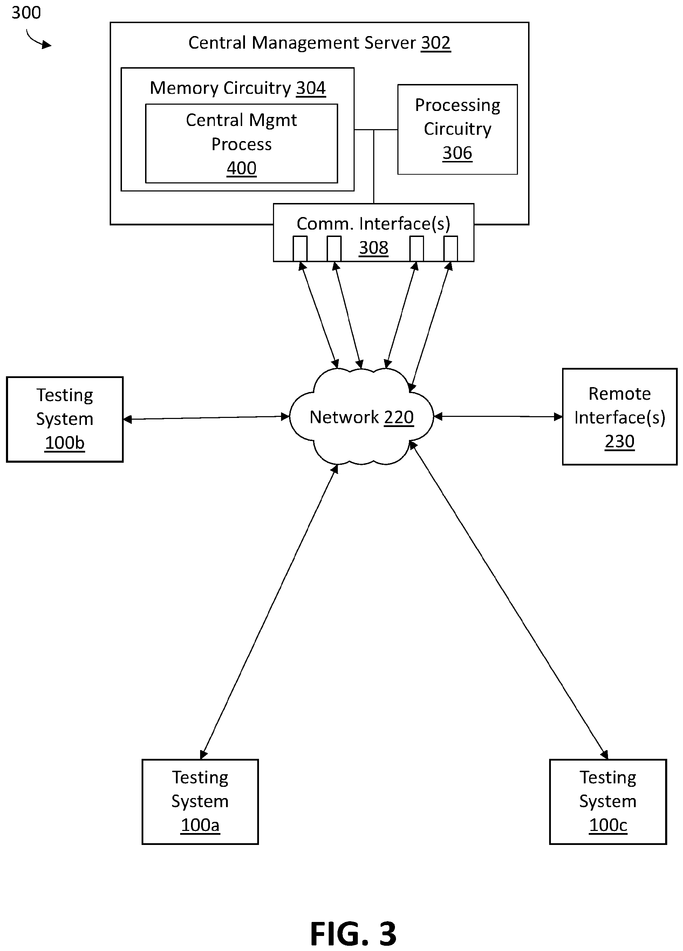

FIG. 3 shows an example of a distributed material testing system 300 having a central management server 302 connected with several material testing systems 100 through a network 220. While a certain number of material testing systems 100 are shown in the example of FIG. 3, in some examples, more or fewer material testing systems 100 may be connected with the central management server 302. Though a single central management server 302 is shown in the example of FIG. 3, in some examples, the central management server 302 may be comprised of several servers.

While shown as separate and distinct in FIG. 3, in some examples, the central management server 302 may be implemented via a testing workstation 202 of one of the connected material testing systems 100. For example, the components of the testing workstation 202 may operate (at least at some times and/or in some capacity) as components of a central management server 302. As another example, machine readable instructions stored in the workstation memory circuitry 226 may allow the testing workstation 202 to operate (at least at some times) as a central management server 302.

In the example of FIG. 3, the central management server 302 includes several server communication interfaces 308. In some examples, the server communication interface(s) enable and/or facilitate connections and/or communications with the network 220 and/or material testing systems 100 (via the communication interface(s) 218). In some examples, one or more of the server communication interfaces 308 are network interfaces. In some examples, one or more of the server communication interfaces 308 comprise hardware, firmware, and/or software configured to facilitate communication between the central management server 302 and one or more external networks, systems, and/or devices (e.g., the network 220 and/or material testing systems 100).

In some examples, each material testing system 100 sends (e.g. previously recorded and/or concurrently acquired) data to the central management server 302 through the connection with the central management server 302 (and/or server communication interface(s) 308). In some examples, the data may be sent to the central management server 302 in response to a user information request (e.g., provided via the UI 204 and/or remote interface(s) 230).

For example, each material testing system 100 may send system data pertaining to the material testing system 100 to the central management server 302. As another example, each material testing system 100 may send user data pertaining to a user (and/or team) using the material testing system 100 to the central management server 302. As another example, each material testing system 100 may send event data pertaining to system events to the central management server 302. As another example, each material testing system 100 may send test data pertaining to tests that are setup, executed, and/or analyzed using the material testing system 100 to the central management server 302.

In some examples, test data indicates the date and/or time when a material testing process 250 is being executed, when the testing workstation 202 and/or testing machine 102 is being utilized to setup, perform, and/or analyze test results of a test, and/or when the testing workstation 202 and/or testing machine 102 is in a test state (and/or which test state). In some examples, the test data is data representative of one or more (e.g., test, specimen, analysis, etc.) parameters used to setup, perform, and/or analyze test results of a test. In some examples, the test data is representative of the test results of the test of the material testing specimen 128. In some examples, the test data is representative of measurement data (e.g., received from the sensors(s) 126 of the material testing machine 102 during a test) and/or a date/time when measurements were taken and/or measurement data captured.

In some examples, each material testing system 100 may additionally, or alternatively, send system data to the central management server 302. In some examples, system data is data representative of information relating to the material testing system 100. For example, system data may include a system identifier of the material testing system 100 and/or an operational status of the material testing system 100 (and/or testing workstation 202, material testing machine 102, etc.).

In some examples, system data may additionally, or alternatively, include a workstation identifier, model, software version, and/or other information relating to a testing workstation 202 of the material testing system 100. In some examples, system data may additionally, or alternatively, include a machine identifier, machine model, manufacturing date, description, and/or other information relating to a material testing machine 102 of the material testing system 100. In some examples, system data may additionally, or alternatively, include identifiers, models, descriptions, capacities, calibrations, measurements, and/or other information relating to one or more sensors 126 of the material testing machine 102.

In some examples, each material testing system 100 may additionally, or alternatively, send user data to the central management server 302. In some examples, user data is data indicating which user(s) and/or team(s) are operating a material testing system 100 at which date(s)/time(s). In some examples, user data may additionally, or alternatively, indicate which user(s) and/or team(s) setup, executed, and/or analyzed results from which test(s) (and/or when this occurred).

In some examples, each material testing system 100 may additionally, or alternatively, send event data to the central management server 302. In some examples, event data is data representative of (and/or relating to) one or more events that occurred pertaining to a material testing system 100. In some examples, event data may additionally, or alternatively, indicate a date/time when an event occurred, a type of event that occurred, a description of the event, and/or documentation of the event. In some examples, types of events may include login/logout events, message events, service events, calibration events, test (e.g., setup, execution, analysis, etc.) events, and/or malfunction/error events.

In some examples, the testing workstation 202 automatically records event data when the event occurs. For example, the material testing machine 102 and/or a sensor 126 may report to the testing workstation 202 when a machine/sensor malfunction/error occurs, and/or details of the malfunction/error, and the testing workstation 202 may record that information as event data. As another example, the testing workstation 202 may automatically record when a user logs in/out, sends a message, and/or sets up, performs, and/or analyzes results of a test, as well as details pertaining to the login/logout, message, and/or testing.

In some examples, event data is provided to the testing workstation 202 for recordation before or after the event occurs, such as, for example, via input by a user using the UI 204. For example, a service technician might manually provide information (and/or documentation) pertaining to a service event before or after the service event. As another example, an operator might manually provide information (and/or documentation) pertaining to a calibration event before or after the calibration event. Thereafter, the testing workstation 202 may record the event data and/or send the event data to the central management server 302.

In some examples, the central management server 302 records the data sent by each material testing system 100. In the example of FIG. 3, the central management server 302 includes server memory circuitry 226 via which the data may be recorded. In some examples, the server memory circuitry 226 comprises a central data repository in which the data is stored. In some examples, the distributed material testing system 100 may alternatively, or additionally, include a separate central data repository that is in communication with the central management server 302 and that stores the data.

In some examples, storing data from several material testing systems 100 in a central data repository and/or central management server 302 enables the data to be accessed from any workstation 202, terminal, UI 204, remote interfaced 230, and/or other interface connected to the central management server 302 (e.g., through network 220). In some examples, the central management server 302 is additionally configured to identify relevant system management information using the collected data, and allow users to access the system management information from any workstation 202, terminal, UI 204, remote interfaced 230, and/or other interface connected to the central management server 302.

In some examples, the collected data and/or identified system management information may be used to compare and/or contrast the operational efficiency and/or utilization of different material testing systems 100. In some examples, the system management information may additionally be helpful for auditing, monitoring testing activities, identifying and/or addressing issues, and/or planning for future tests. In some examples, the central management server 302 collects/stores the data and/or identifies the relevant system management information in response to user input (e.g., provided via the UI 204 and/or remote interface(s) 230).

In the example of FIG. 3, the central management server 302 further includes server processing circuitry 306. In some examples, the server processing circuitry 306 may comprise one or more processors. In some examples, the server processing circuitry 224 is configured to execute machine readable instructions stored in the server memory circuitry 304, and/or query the central data repository.

In the example of FIG. 3, the server memory circuitry 226 is shown as storing a central management process 400. While shown as part of the server memory circuitry 226 in the example of FIG. 3, in some examples, the central management process 400 may be implemented using discrete circuitry (e.g., of the server processing circuitry 306). In some examples, the central management process 400 is implemented using non-transitory machine readable instructions stored in the server memory circuitry 226 and/or executed by the server processing circuitry 306.

In some examples, the central management process 400 is configured to collect data from the material testing systems 100 of the distributed material testing system 100, and identify relevant (status, statistical, historical, etc.) system management information pertaining to those material testing systems 100. By centralizing the data collection and system management information identification, the collected data and/or system management information can be accessed from any workstation 202, terminal, UI 204, remote interfaced 230, and/or other interface connected to the central management server 302. In some examples, the collected data and/or identified system management information may be used to compare and/or contrast the operational efficiency and/or utilization of different material testing systems 100. In some examples, the system management information may additionally be helpful for auditing, monitoring testing activities, identifying and/or addressing issues, and/or planning for future tests.

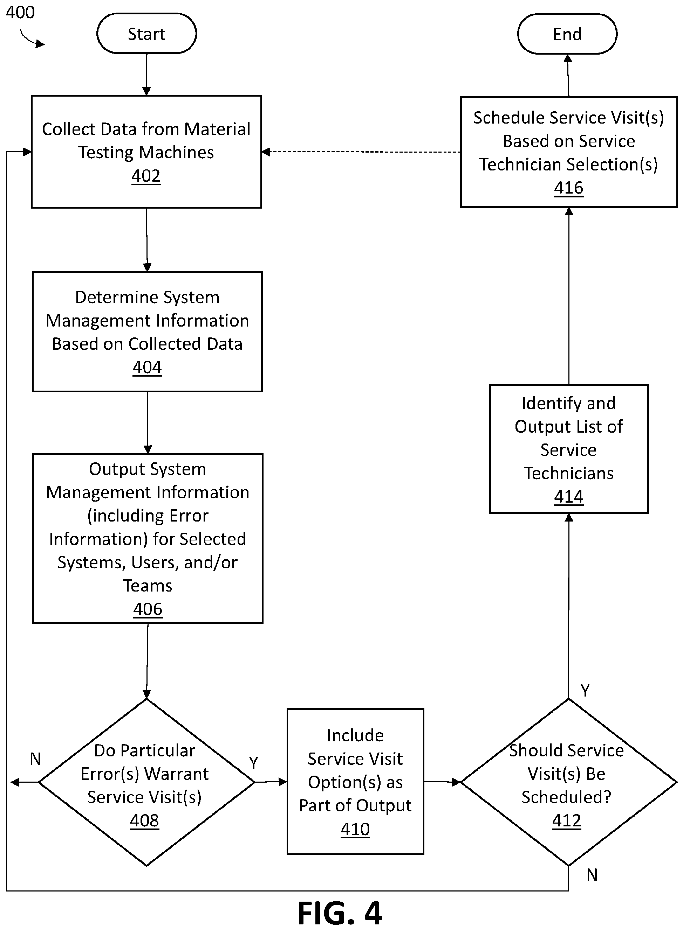

FIG. 4 is a flow diagram showing example operation of the central management process 400. In some examples, before using and/or progressing through the central management process 400, a user may be required to login and/or be authenticated (e.g., using user credentials, biometrics, RFID/NFC/Bluetooth/barcode devices, etc.). In some examples, different instances of the central management process 400 may execute for different users and/or teams. While the central management process 400 is sometimes described below as conducting certain actions for the sake of understanding and convenience, it should be understood that one or more of the above described components of the distributed material testing system 300 (e.g., the server processing circuitry 306, remote interface(s) 230, material testing system(s) 100, etc.) may undertake the actions on behalf (and/or according to instructions) of the central management process 400.

In the example of FIG. 4, the central management process 400 begins at block 402, where the central management process 400 collects data from the various material testing systems 100 of the distributed material testing system 100, as discussed above. In some examples, the collected data includes test data, system data, and/or event data, such as discussed above. In some examples, the data is collected in response to some (e.g., user) input (e.g., provided via a UI 204 and/or remote interface 230).

In some examples where the central management server 302 is implemented as part of a testing workstation 202 of a particular material testing system 100, the central management process 400 may only be concerned with data pertaining to that particular testing system 100. In such examples, the central management process 400 may only collect data from that particular testing system 100 at block 402.

After block 402, the central management process 400 proceeds to block 404 where the central management process 400 determines various system management information based on the data collected at block 402. After block 404, the central management process 400 proceeds to block 406 where the central management process 400 provides one or more human perceptible outputs of some or all of the system management information determined at block 404 (e.g., graphics, images, sounds, text, vibrations, etc. output via a UI 204 and/or remote interface 230).

In some examples, the central management process 400 determines and/or outputs the system management information in response to one or more inputs/selections (e.g., made by a user via a UI 204 and/or remote interface). In some examples, the central management process 400 determines and/or outputs system management information relating to selected users, teams, and/or material testing systems 100. In some examples, the central management process 400 restricts which users, teams, and/or material testing systems 100 may be selected, and/or what collected data and/or system management information may be accessed, based on the permissions and/or authorizations of the logged in user/team, and/or the available/connected material testing systems 100.

In some examples, the system management information determined at block 404 includes statistical metrics. In some examples, the system management information determined at block 404 includes historical information. In some examples, the system management information determined at block 404 includes system status information.

In some examples, system status information is information pertaining to an identify and/or status of a material testing system 100. For example, system status information may include identifiers, models, descriptions of the material testing systems 100, material testing machines 102, testing workstations 202, and/or sensors 126. In some examples, system status information additionally, or alternatively, includes calibration information pertaining to the material testing machine 102 and/or sensor(s) 126 (e.g., date/time last calibrated, date/time of next calibration, etc.). In some examples, system status information additionally, or alternatively, includes an operational and/or connection status of the material testing system 100, material testing machine 102, testing workstation 202, and/or sensor(s) 126. In some examples, the system status information is presented in response to selection of a particular material testing system 100.

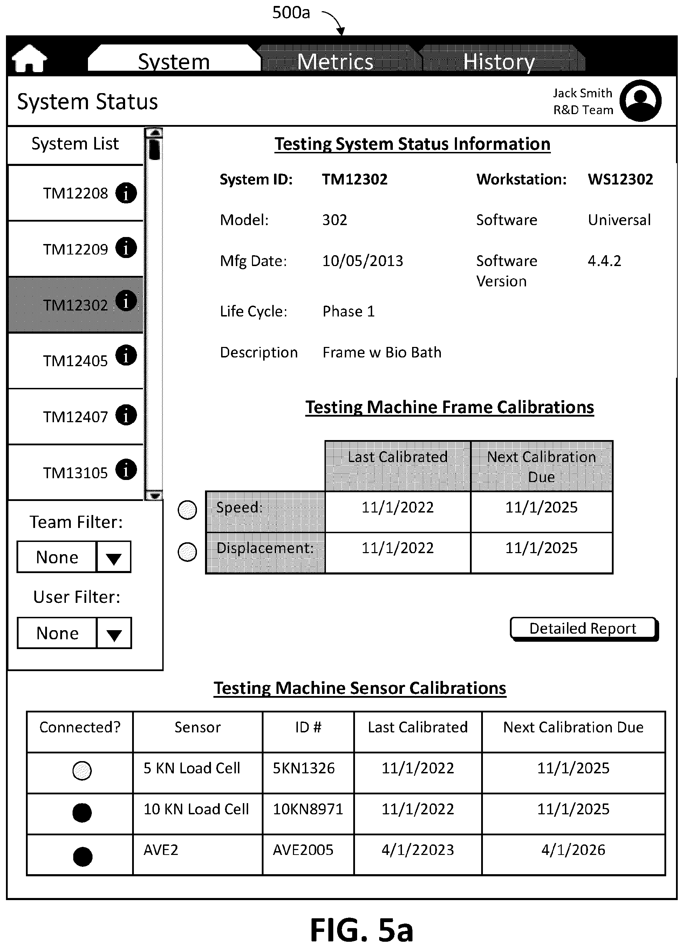

FIG. 5a shows an example of a system status graphical user interface (GUI) 500a that might be used to output system status information at block 406 (e.g., via a UI 204 and/or remote interface 230). As shown, the system status GUI 500a includes a system list of different material testing systems 100. Each entry shown in the system list is an identifier of a particular material testing system 100. As shown, each system identifier is positioned proximate to an "i" icon that may be selected (e.g., by positioning a selection cursor over the icon) to bring up more information about the particular material testing system 100.

The system status GUI 500a is further shown as including drop down dialog boxes that might be used to filter the list of selectable material testing systems 100. For example, the system list might be filtered so that only material testing systems 100 authorized to be used and/or accessed by particular users/teams are shown in the system list. In some examples, the central management process 400 may automatically filter the system list to reflect the permissions and/or authorizations of the logged in user. In some examples, the server memory circuitry 226 stores user data and/or permission data that may be used by the central management process 400 to determine the permissions and/or authorizations of the logged in user.

In the example of FIG. 5a, the user has selected the material testing system 100 corresponding to the system identifier TM12302, as indicated by the highlighting of that particular entry in the system list. In view of the selection, the system status GUI 500a is shown listing system status information pertaining to the selected material testing system 100, the material testing machine 102 of the material testing system 100, and the sensor(s) 126 of the material testing machine 102 of the material testing system 100. In the example of FIG. 5a, the system status GUI 500 is also shown as including a "Detailed Report" button that can be selected to present a more detailed report of the system status information.

While particular status information pertaining to the selected material testing system 100 is shown in the example system status GUI 500a of FIG. 5a, in some examples, additional, or alternative, information may be shown. For example, the GUI 500a might indicate whether a (and/or what) test is currently being setup/performed/analyzed, a progress of the test, what team/user is currently using the material testing system 100 and/or testing, a number of specimens tested/still to be tested in sample, current measurements of sensor(s) 126, current positions/displacements of crosshead 120 and/or fixture(s) 122, and/or other information. In some examples, the GUI 500a may use different colors to indicate whether certain status information is good, bad, cautionary, or neutral.

In some examples, the system management information determined at block 404 and/or output at block 406 includes one or more statistical metrics (e.g., pertaining to particular material testing systems 100, teams, and/or users). In some examples, the statistical metrics include a utilization metric indicative of an amount of testing done by a selected material testing system 100, user, and/or team.

In some examples, a utilization metric indicates how many or how often samples have been tested, material specimens 128 have been tested, tests have been setup/performed, and/or test results have been analyzed by a selected material testing machine 102, user, and/or team over a selected time period. In some examples, the utilization metric indicates how much, how often, and/or what percentage of time a selected material testing machine 102 is used/utilized to setup, execute, and/or analyze results of a test over a selected time period. In some examples, the utilization metric indicates how much, how often, and/or what percentage of time a particular user or team is setting up, executing, and/or analyzing results of a test over a selected time period.

In some examples where the utilization metric determined at block 404 is a utilization percentage, the central management process 400 may determine utilization percentage based on a quotient of active test time divided by total time. In some examples, active test time is time in a test state and/or time spent doing test setup, test execution, and/or test result analysis. In some examples, time spent actually performing a test may be weighted more and/or considered more/fully active, while time spent doing test setup and/or analyzing test results may be weighted less and/or considered less/partially active.

In some examples, total time may be all time over the selected time period (e.g., 24 hours where the selected time period is one day). In some examples, total time may be typical business operation days/times (e.g., 9a-5pm where the selected time period is a weekday, and/or no time where the selected time period is a weekend). In some examples, total time may be some customized subset of the selected time period determined based on custom operation time information (e.g., user input indicating actual business operation dates/times for particular systems 100, users, and/or teams).

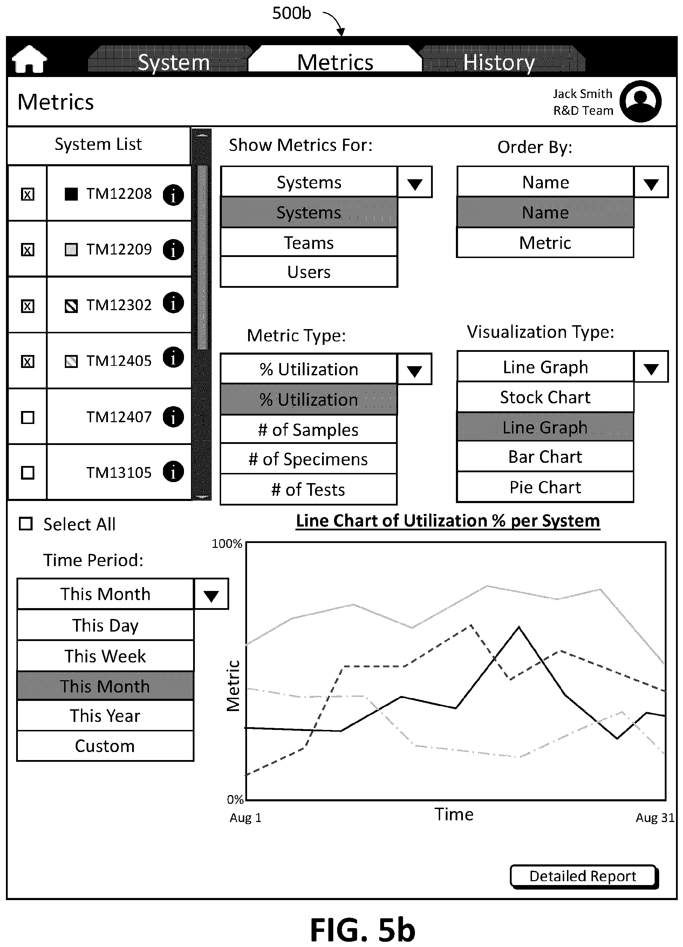

FIGS. 5b-5d show examples of statistical metrics presented in statistical metric GUIs 500b-500d. In the example of FIG. 5b, the statistical metric GUI 500b shows a line chart depicting utilization percentage over a month for several material testing systems 100 selected from a selectable system list of material testing systems 100 (similar to the system list of FIG. 5a, except allowing for multiple selections). While one line is shown for each selected material testing system 100 in the example line chart of FIG. 5b, in some examples, the line chart may instead include only one line that represents a percentage of the selected material testing systems 100 that were being utilized at a particular point in time.

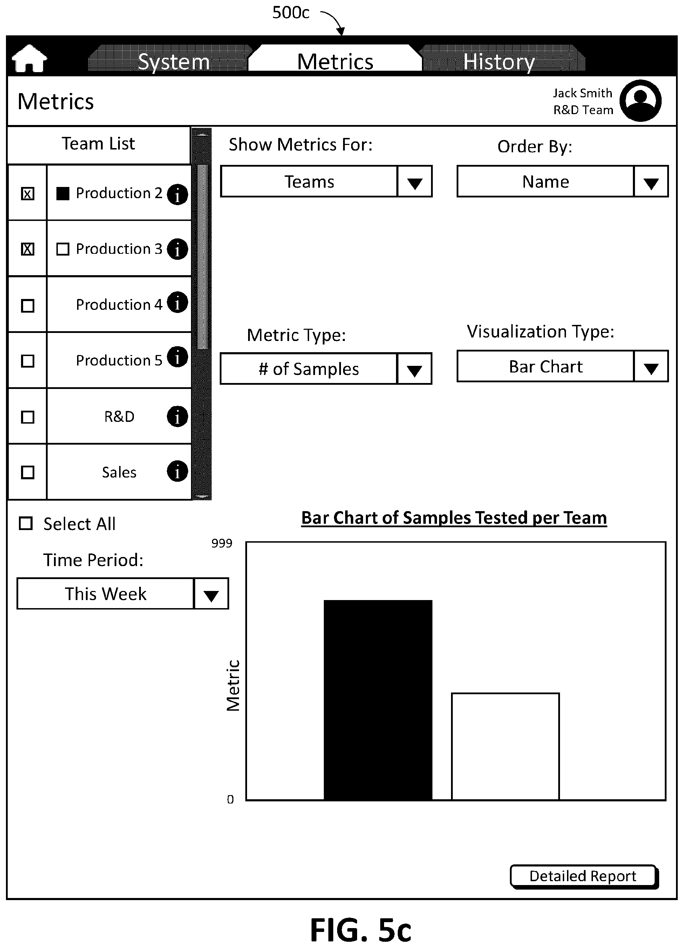

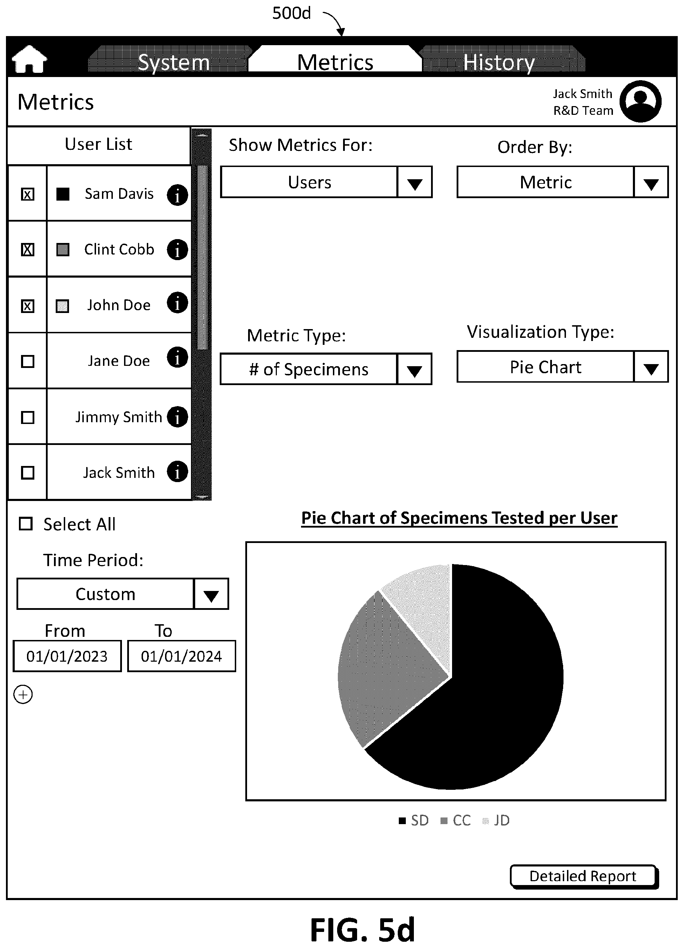

In the example of FIG. 5c, the statistical metric GUI 500c includes a bar chart showing a number of samples tested by selected teams over a week. A team list of selectable teams is shown allowing for a user to select one or more teams for inclusion in the bar chart. In the example of FIG. 5d, the statistical metric GUI 500d includes a pie chart showing a number of material specimens 128 tested by selected users over a year. A user list of selectable users is shown allowing for a user to select one or more users for inclusion in the pie chart. The list of users is also shown as being ordered by the number of material specimens 128 tested by each user (rather than by name/identifier as in FIGS. 5b-5c).

In some examples, the system management information determined at block 404 and/or output at block 406 includes historical information. In some examples, the historical information is information pertaining to one or more events that occurred in the history of a selected material testing system 100, team, and/or user. In some examples, the one or more events include login/logout events, message events, service events, calibration events, test (e.g., setup, execution, analysis, etc.) events, sensor measurement events, and/or malfunction/error events.

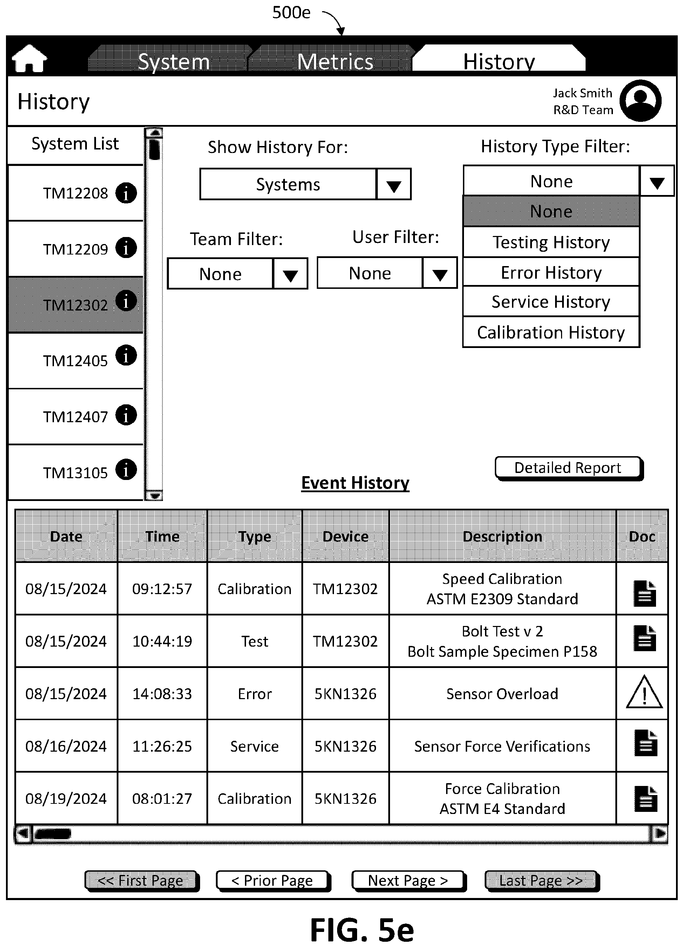

FIG. 5e shows an example of historical information presented in a historical GUI 500e, such as might be output at block 406 (e.g., via a UI 204 and/or remote interface 230). As shown, the historical GUI 500e includes a system list of selectable material testing systems 100, similar to the system lists of FIGS 5a-5v (though, in some examples, the list might instead be a list of teams and/or users). The historical GUI 500e further includes an event history table showing historical events for the selected material testing system 100, as well as historical information pertaining to each event.

In the example of FIG. 5e, the event history table shows historical information pertaining to the date/time of the event, the type of event, the device to which the event pertains (if applicable), a description of the event, and a link to additional documentation pertaining to the event. In some examples, the additional documentation may include test results, calibration certificates, service reports, error reports, and/or service requests. While certain historical information is shown for in the example of FIG. 5e, in some examples, additional, or alternative, historical information may be shown when outputting historical information at block 406 of the central management process 400.

In the example of FIG. 4, after block 406, the central management process 400 proceeds to block 408, where the central management process 400 determines whether one or more of the error and/or malfunction events determined at block 406 and/or output at block 408 warrant a service visit. In some examples, this determination is based on a severity and/or type of the error, the device to which the error pertains (e.g., whether such a device can be fixed via service visit), the logged in user (e.g., whether the user is authorized to arrange a service visit), and/or other information.

In the example of FIG. 4, the central management process 400 proceeds to block 410 after block 408 if the central management process 400 determines that one or more error and/or malfunction events determined at block 404 do merit a service visit. At block 410, the central management process 400 provides the option for a service visit to be requested. For example, the central management process 400 might provide a service visit request link as part of the output of block 406. FIG. 5e shows an example of a service visit link (represented by an exclamation point in a triangle) presented in the additional documentation column of the example historical GUI 500e of FIG. 5e.

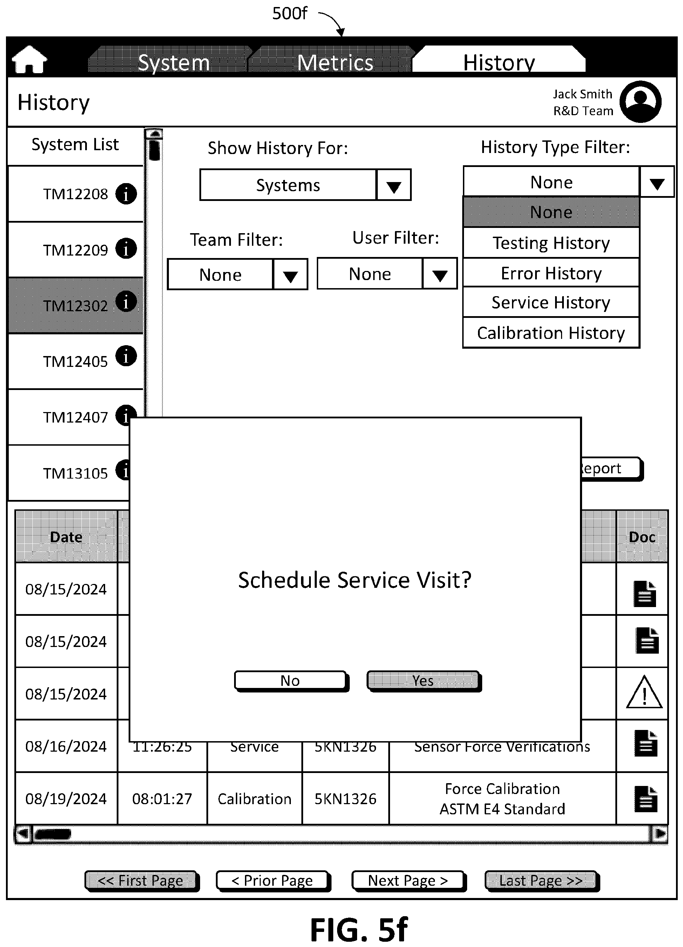

In the example of FIG. 4, after block 410, the central management process 400 proceeds to block 412, where the central management process 400 determines whether a service visit should be scheduled for one or more of the errors/malfunctions for which a service visit option was provided at block 410. In some examples, this determination is based on whether the user has provided an input selecting the service visit request link (e.g., via the UI 204 and/or remote interface 230). FIG. 5f shows an example service visit option GUI 500f that might be shown to a user to give them the option of scheduling a service visit (e.g., in response to a user selecting the service visit request link in the GUI 500e of FIG. 5e).

If the central management process 400 determines that a service visit should be scheduled at block 412, the central management process 400 proceeds to block 414, where the central management process 400 identifies one or more service technicians qualified to service the selected error/malfunction. In some examples, the identification of the service technician(s) is based on information about the error/malfunction, and/or information about the service technician(s). Relevant information about the service technician that might be considered when identifying qualified service technicians may include proximity to the material testing system 100 having the error/malfunction, recent history addressing similar errors/malfunctions, expertise addressing similar errors/malfunctions, dates/times of technician availability, and/or other information. In some examples, the central management process 400 may access a list (e.g., stored in server memory circuitry 304) of preferred service technicians and/or service companies for particular material testing systems 100, particular malfunctions/errors, and/or in general when making the identification(s) at block 414.

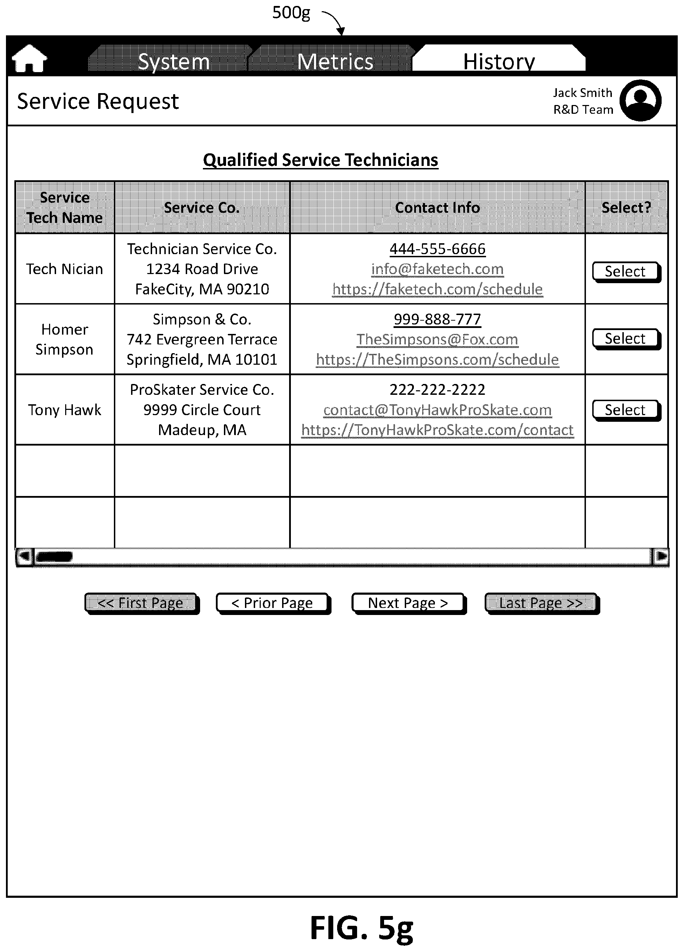

FIG. 5g shows an example of a technician list GUI 500g that includes a list of qualified service technicians, as well as technician information for each service technician. As shown, the technician information includes contact information for each service technician. In the example of FIG. 5g, some of the contact information is hyperlinked, such that selection of the contact information might prompt the system to facilitate contact with the service technician (e.g., via service center portal/website, electronic mail, and/or voice over internet protocol). A "select" button is further shown, the selection of which, in some examples, might prompt the central management process 400 to attempt to automatically schedule a service visit (e.g., within some user specified date, time, location, and/or other parameters). While some example technician information is shown in the example of FIG. 5g, in some examples, additional, or alternative technician information may be provided.

In the example of FIG. 4, once a user selects a particular service technician at block 414, the central management process 400 proceeds to block 416 where the central management process 400 attempts to schedule a service visit based on the selection at block 414 (and/or within some user specified date, time, location, and/or other parameters). In some examples, the central management process 400 may attempt to schedule the service visit using a service center portal/website of the selected service company, electronic mail, and/or voice over internet protocol. While shown as ending after block 416 in the example of FIG. 4, in some examples, the central management process 400 instead returns to block 402 after block 416.

The disclosed distributed material testing system 300 and central management process 400 collects data from the material testing systems 100 of the distributed material testing system 100 using a central management server 302. In some examples, the central management process 400 is configured to identify relevant system management information using the collected data, and allow users to access the system management information from any workstation 202, terminal, UI 204, remote interfaced 230, and/or other interface connected to the central management server 302. In some examples, the collected data and/or identified system management information may be used to compare and/or contrast the operational efficiency and/or utilization of different material testing systems 100. In some examples, the system management information may additionally be helpful for auditing, monitoring testing activities, identifying and/or addressing issues, and/or planning for future tests.

The present methods and/or systems may be realized in hardware, software, or a combination of hardware and software. The present methods and/or systems may be realized in a centralized fashion in at least one computing system, or in a distributed fashion where different elements are spread across several interconnected computing or cloud systems. Any kind of computing system or other apparatus adapted for carrying out the methods described herein is suited. A typical combination of hardware and software may be a general-purpose computing system with a program or other code that, when being loaded and executed, controls the computing system such that it carries out the methods described herein. Another typical implementation may comprise an application specific integrated circuit or chip. Some implementations may comprise a non-transitory machine-readable (e.g., computer readable) medium (e.g., FLASH drive, optical disk, magnetic storage disk, or the like) having stored thereon one or more lines of code executable by a machine, thereby causing the machine to perform processes as described herein.

While the present method and/or system has been described with reference to certain implementations, it will be understood by those skilled in the art that various changes may be made and equivalents may be substituted without departing from the scope of the present method and/or system. In addition, many modifications may be made to adapt a particular situation or material to the teachings of the present disclosure without departing from its scope. Therefore, it is intended that the present method and/or system not be limited to the particular implementations disclosed, but that the present method and/or system will include all implementations falling within the scope of the appended claims.

As used herein, "and/or" means any one or more of the items in the list joined by "and/or". As an example, "x and/or y" means any element of the three-element set {(x), (y), (x, y)}. In other words, "x and/or y" means "one or both of x and y". As another example, "x, y, and/or z" means any element of the seven-element set {(x), (y), (z), (x, y), (x, z), (y, z), (x, y, z)}. In other words, "x, y and/or z" means "one or more of x, y and z".

As utilized herein, the terms "e.g.," and "for example" set off lists of one or more non-limiting examples, instances, or illustrations.

As used herein, the terms "coupled," "coupled to," and "coupled with," each mean a structural and/or electrical connection, whether attached, affixed, connected, joined, fastened, linked, and/or otherwise secured. As used herein, the term "attach" means to affix, couple, connect, join, fasten, link, and/or otherwise secure. As used herein, the term "connect" means to attach, affix, couple, join, fasten, link, and/or otherwise secure.

As used herein the terms "circuits" and "circuitry" refer to physical electronic components (i.e., hardware) and any software and/or firmware ("code") which may configure the hardware, be executed by the hardware, and or otherwise be associated with the hardware. As used herein, for example, a particular processor and memory may comprise a first "circuit" when executing a first one or more lines of code and may comprise a second "circuit" when executing a second one or more lines of code. As utilized herein, circuitry is "operable" and/or "configured" to perform a function whenever the circuitry comprises the necessary hardware and/or code (if any is necessary) to perform the function, regardless of whether performance of the function is disabled or enabled (e.g., by a user-configurable setting, factory trim, etc.).

As used herein, a control circuit may include digital and/or analog circuitry, discrete and/or integrated circuitry, microprocessors, DSPs, etc., software, hardware and/or firmware, located on one or more boards, that form part or all of a controller, and/or are used to control a welding process, and/or a device such as a power source or wire feeder.

As used herein, the term "processor" means processing devices, apparatus, programs, circuits, components, systems, and subsystems, whether implemented in hardware, tangibly embodied software, or both, and whether or not it is programmable. The term "processor" as used herein includes, but is not limited to, one or more computing devices, hardwired circuits, signal-modifying devices and systems, devices and machines for controlling systems, central processing units, programmable devices and systems, field-programmable gate arrays, application-specific integrated circuits, systems on a chip, systems comprising discrete elements and/or circuits, state machines, virtual machines, data processors, processing facilities, and combinations of any of the foregoing. The processor may be, for example, any type of general purpose microprocessor or microcontroller, a digital signal processing (DSP) processor, an application-specific integrated circuit (ASIC), a graphic processing unit (GPU), a reduced instruction set computer (RISC) processor with an advanced RISC machine (ARM) core, etc. The processor may be coupled to, and/or integrated with a memory device.

As used, herein, the term "memory" and/or "memory device" means computer hardware or circuitry to store information for use by a processor and/or other digital device. The memory and/or memory device can be any suitable type of computer memory or any other type of electronic storage medium, such as, for example, read-only memory (ROM), random access memory (RAM), cache memory, compact disc read-only memory (CDROM), electro-optical memory, magneto-optical memory, programmable read-only memory (PROM), erasable programmable read-only memory (EPROM), electrically-erasable programmable read-only memory (EEPROM), a computer-readable medium, or the like. Memory can include, for example, a non-transitory memory, a non-transitory processor readable medium, a non-transitory computer readable medium, non-volatile memory, dynamic RAM (DRAM), volatile memory, ferroelectric RAM (FRAM), first-in-first-out (FIFO) memory, last-in-first-out (LIFO) memory, stack memory, non-volatile RAM (NVRAM), static RAM (SRAM), a cache, a buffer, a semiconductor memory, a magnetic memory, an optical memory, a flash memory, a flash card, a compact flash card, memory cards, secure digital memory cards, a microcard, a minicard, an expansion card, a smart card, a memory stick, a multimedia card, a picture card, flash storage, a subscriber identity module (SIM) card, a hard drive (HDD), a solid state drive (SSD), etc. The memory can be configured to store code, instructions, applications, software, firmware and/or data, and may be external, internal, or both with respect to the processor.
Certain embodiments of the invention are described in the following clauses:
Clause 1. A non-transitory computer readable medium comprising machine readable instructions which, when executed by processing circuitry, cause the processing circuitry to:
   receive test data from one or more material testing systems, the test data relating to testers, test parameters, test results, or test timings of a plurality of tests conducted using the one or more material testing systems;
   determine a utilization metric based on the test data, the utilization metric indicating how much or how often a particular material testing system, or the one or more of material testing systems were used during a selected time period;
   output, via a user interface, a human perceptible representation of the utilization metric.
Clause 2. The non-transitory computer readable medium of clause 1, wherein the utilization metric comprises (i) a number of tests performed by one or more testers, the particular material testing system, or the one or more material testing systems, during the selected time period, (ii) an amount of samples or specimens tested by the one or more testers, the particular material testing system, or the one or more material testing systems, during the selected time period, or (iii) a fraction or percentage of the one or more testers, or the one or more material testing systems, that were performing a test at particular times during the selected time period.
Clause 3. The non-transitory computer readable medium of clause 1, wherein the human perceptible representation comprises a first human perceptible representation, and the non-transitory computer readable medium further comprises machine readable instructions which, when executed by the processing circuitry, cause the processing circuitry to:
   receive system data from the one or more material testing systems, the system data pertaining to information about the one or more material testing systems;
   identify the particular material testing system based on a user selection received via the user interface;
   determine particular system data relevant to the particular material testing system based on the system data, the test data, and the particular material testing system; and
   output, via the user interface, a second human perceptible representation of the particular system data.
Clause 4. The non-transitory computer readable medium of clause 3, wherein the particular system data comprises a system identifier of the particular material testing system, a current testing status of the particular material testing system, a current tester of the particular material testing system, event information relating to one or more events pertaining to the particular material testing system, a machine identifier of a particular material testing machine of the particular material testing system, a date of manufacture of the particular material testing machine, a description of the particular material testing machine, sensor information relating to one or more sensors of the particular material testing machine, calibration information relating to a calibration of the one or more sensors or the particular material testing machine, a workstation identifier of a particular testing workstation of the particular material testing system, or software information relating to a software running on the particular testing workstation.
Clause 5. The non-transitory computer readable medium of clause 1, further comprising machine readable instructions which, when executed by the processing circuitry, cause the processing circuitry to:
   receive system data from a particular material testing system of the one or more material testing systems, the system data comprising error data indicating that a sensor or other machine component of a particular material testing machine of the particular material testing system has had a malfunction;
   determine, based on the error data, whether the malfunction warrants servicing of the sensor or the particular material testing machine;
   in response to determining the malfunction does warrant servicing of the sensor or the particular material testing machine, output a query, via the user interface, as to whether a service visit should be scheduled; and
   in response to receiving a positive response to the query, communicate with a service center, via the central server, to schedule the service visit.
Clause 6. The non-transitory computer readable medium of clause 5, further comprising machine readable instructions which, when executed by the processing circuitry, cause the processing circuitry to:
   identify one or more qualified service technicians based on the malfunction, the error data, the type of sensor or other machine component, the test data, or a service history; and
   outputting, via the user interface, a list identifying the one or more qualified service technicians.
Clause 7. The non-transitory computer readable medium of clause 6, further comprising machine readable instructions which, when executed by the processing circuitry, cause the processing circuitry to communicate with the service center to schedule the service visit in response to receiving, via the user interface, a selection of a particular service technician and identifying the service center of the particular service technician.
Clause 8. A system, comprising:
   one or more material testing systems configured to conduct a plurality of tests on a plurality of material specimens, and transmit test data relating to testers, test parameters, test results, or test timings of the plurality of tests;
   a central server configured to receive the test data from the one or more material testing systems, the central server comprising central server processing circuitry configured to determine a utilization metric based on the test data, the utilization metric indicating how much or how often a particular material testing system, or the plurality of material testing systems were used during a selected time period;
   a user interface in communication with the central server, the user interface being configured to output a human perceptible representation of the utilization metric.
Clause 9. The system of clause 8, wherein the utilization metric comprises (i) a number of tests performed during the selected time period by one or more testers, the particular material testing system, or the one or more material testing systems, (ii) an amount of samples or specimens tested during the selected time period by the one or more testers, the particular material testing system, or the one or more material testing systems, or (iii) a fraction or percentage of the one or more testers, or the one or more material testing systems, that were preparing, performing, or analyzing results of a test at particular times during the selected time period.
Clause 10. The system of clause 8, wherein:
   the human perceptible representation comprises a first human perceptible representation,
   the one or more material testing systems are further configured to send system data to the central server, the system data pertaining to information about the one or more material testing systems,
   the central server processing circuitry is further configured to identify the particular material testing system based on a user selection, and determine particular system data relevant to the particular material testing system based on the system data, the test data, and the particular material testing system, and
   the user interface is configured to receive the user selection as an input, and output a second human perceptible representation of the particular system data.
Clause 11. The system of clause 10, wherein the particular system data comprises a system identifier of the particular material testing system, a current testing status of the particular material testing system, a current tester of the particular material testing system, event information relating to one or more events pertaining to the particular material testing system, a machine identifier of a particular material testing machine of the particular material testing system, a date of manufacture of the particular material testing machine, a description of the particular material testing machine, sensor information relating to one or more sensors of the particular material testing machine, calibration information relating to a calibration of the one or more sensors or the particular material testing machine, a workstation identifier of a particular testing workstation of the particular material testing system, or software information relating to a software running on the particular testing workstation.
Clause 12. The system of clause 8, wherein:
   the plurality of material testing systems are further configured to send system data to the central server, the system data comprising error data indicating that a sensor or other machine component of a particular material testing machine of the particular material testing system has had a malfunction, and
   the central server processing circuitry is further configured to:
      determine, based on the error data, whether the malfunction warrants servicing of the sensor or the particular material testing machine,
      in response to determining the malfunction does warrant servicing of the sensor or the particular material testing machine, output a query, via the user interface, as to whether a service visit should be scheduled, and
      in response to receiving a positive response to the query, via the user interface, communicate with a service center to schedule the service visit.
Clause 13. The system of clause 12, wherein the central server processing circuitry is further configured to:
   identify one or more qualified service technicians based on the malfunction, the error data, the type of sensor or other machine component, the test data, or a service history, and
   output, via the user interface, a list identifying the one or more qualified service technicians.
Clause 14. The system of clause 13, wherein the user interface is configured to receive a selection of a particular service technician from the list identifying the one or more qualified service technicians, the central server processing circuitry is configured to identify the service center of the particular service technician, and the central server is configured to communicate with the service center to schedule the service visit.
Clause 15. A method, comprising:
   receiving, at a central server, test data from one or more material testing systems, the test data relating to testers, test parameters, test results, or test timings of a plurality of tests conducted using the one or more material testing systems;
   determining, at the central server, a utilization metric based on the test data, the utilization metric indicating how much or how often a particular material testing system, or the one or more material testing systems were used for testing during a selected time period; and
   outputting, via a user interface, a human perceptible representation of the utilization metric.
Clause 16. The method of clause 15, wherein the utilization metric comprises (i) a number of tests performed by one or more testers, the particular material testing system, or the one or more material testing systems, during the selected time period, (ii) an amount of samples or specimens tested by the one or more testers, the particular material testing system, or the one or more material testing systems, during the selected time period, or (iii) a fraction or percentage of the one or more testers, or the one or more material testing systems, that were performing a test at particular times during the selected time period.
Clause 17. The method of clause 15, wherein the human perceptible representation comprises a first human perceptible representation, the method further comprising:
   receiving, at the central server, system data from the one or more material testing systems, the system data pertaining to information about the one or more material testing systems;
   identifying, via the central server, the particular material testing system based on a user selection received via the user interface;
   determining particular system data relevant to the particular material testing system based on the system data, the test data, and the particular material testing system; and
   outputting, via the user interface, a second human perceptible representation of the particular system data.
Clause 18. The method of clause 17, wherein the particular system data comprises a system identifier of the particular material testing system, a current testing status of the particular material testing system, a current tester of the particular material testing system, event information relating to one or more events pertaining to the particular material testing system, a machine identifier of a particular material testing machine of the particular material testing system, a date of manufacture of the particular material testing machine, a description of the particular material testing machine, sensor information relating to one or more sensors of the particular material testing machine, calibration information relating to a calibration of the one or more sensors or the particular material testing machine, a workstation identifier of a particular testing workstation of the particular material testing system, or software information relating to a software running on the particular testing workstation.
Clause 19. The method of clause 15, further comprising:
   receiving, at the central server, system data from a particular material testing system of the one or more material testing systems, the system data comprising error data indicating that a sensor or other machine component of a particular material testing machine of the particular material testing system has had a malfunction;
   determining, via the central server, based on the error data, whether the malfunction warrants servicing of the sensor or the particular material testing machine;
   in response to determining the malfunction does warrant servicing of the sensor or the particular material testing machine, outputting a query, via the user interface, as to whether a service visit should be scheduled; and
   in response to receiving a positive response to the query, communicating with a service center, via the central server, to schedule the service visit.
Clause 20. The method of clause 19, further comprising:
   identifying one or more qualified service technicians based on the malfunction, the error data, the type of sensor or other machine component, the test data, or a service history; and
   outputting, via the user interface, a list identifying the one or more qualified service technicians, wherein the central server communicates with the service center to schedule the service visit in response to receiving, via the user interface, a selection of a particular service technician and identifying the service center of the particular service technician.

## Claims

1. A non-transitory computer readable medium comprising machine readable instructions which, when executed by processing circuitry, cause the processing circuitry to:
receive test data from one or more material testing systems, the test data relating to testers, test parameters, test results, or test timings of a plurality of tests conducted using the one or more material testing systems;
determine a utilization metric based on the test data, the utilization metric indicating how much or how often a particular material testing system, or the one or more of material testing systems were used during a selected time period;
output, via a user interface, a human perceptible representation of the utilization metric.

2. The non-transitory computer readable medium of claim 1, wherein the utilization metric comprises (i) a number of tests performed by one or more testers, the particular material testing system, or the one or more material testing systems, during the selected time period, (ii) an amount of samples or specimens tested by the one or more testers, the particular material testing system, or the one or more material testing systems, during the selected time period, or (iii) a fraction or percentage of the one or more testers, or the one or more material testing systems, that were performing a test at particular times during the selected time period.

3. The non-transitory computer readable medium of claim 1 or claim 2, wherein the human perceptible representation comprises a first human perceptible representation, and the non-transitory computer readable medium further comprises machine readable instructions which, when executed by the processing circuitry, cause the processing circuitry to:
receive system data from the one or more material testing systems, the system data pertaining to information about the one or more material testing systems;
identify the particular material testing system based on a user selection received via the user interface;
determine particular system data relevant to the particular material testing system based on the system data, the test data, and the particular material testing system; and
output, via the user interface, a second human perceptible representation of the particular system data, and optionally
wherein the particular system data comprises a system identifier of the particular material testing system, a current testing status of the particular material testing system, a current tester of the particular material testing system, event information relating to one or more events pertaining to the particular material testing system, a machine identifier of a particular material testing machine of the particular material testing system, a date of manufacture of the particular material testing machine, a description of the particular material testing machine, sensor information relating to one or more sensors of the particular material testing machine, calibration information relating to a calibration of the one or more sensors or the particular material testing machine, a workstation identifier of a particular testing workstation of the particular material testing system, or software information relating to a software running on the particular testing workstation.

4. The non-transitory computer readable medium of any one of claims 1 to 3, further comprising machine readable instructions which, when executed by the processing circuitry, cause the processing circuitry to:
receive system data from a particular material testing system of the one or more material testing systems, the system data comprising error data indicating that a sensor or other machine component of a particular material testing machine of the particular material testing system has had a malfunction;
determine, based on the error data, whether the malfunction warrants servicing of the sensor or the particular material testing machine;
in response to determining the malfunction does warrant servicing of the sensor or the particular material testing machine, output a query, via the user interface, as to whether a service visit should be scheduled; and
in response to receiving a positive response to the query, communicate with a service center, via the central server, to schedule the service visit.

5. The non-transitory computer readable medium of claim 4, further comprising machine readable instructions which, when executed by the processing circuitry, cause the processing circuitry to:
identify one or more qualified service technicians based on the malfunction, the error data, the type of sensor or other machine component, the test data, or a service history; and
outputting, via the user interface, a list identifying the one or more qualified service technicians, and optionally
further comprising machine readable instructions which, when executed by the processing circuitry, cause the processing circuitry to communicate with the service center to schedule the service visit in response to receiving, via the user interface, a selection of a particular service technician and identifying the service center of the particular service technician.

6. A system, comprising:
one or more material testing systems configured to conduct a plurality of tests on a plurality of material specimens, and transmit test data relating to testers, test parameters, test results, or test timings of the plurality of tests;
a central server configured to receive the test data from the one or more material testing systems, the central server comprising central server processing circuitry configured to determine a utilization metric based on the test data, the utilization metric indicating how much or how often a particular material testing system, or the plurality of material testing systems were used during a selected time period;
a user interface in communication with the central server, the user interface being configured to output a human perceptible representation of the utilization metric.

7. The system of claim 6, wherein the utilization metric comprises (i) a number of tests performed during the selected time period by one or more testers, the particular material testing system, or the one or more material testing systems, (ii) an amount of samples or specimens tested during the selected time period by the one or more testers, the particular material testing system, or the one or more material testing systems, or (iii) a fraction or percentage of the one or more testers, or the one or more material testing systems, that were preparing, performing, or analyzing results of a test at particular times during the selected time period.

8. The system of claim 6 or claim 7, wherein:
the human perceptible representation comprises a first human perceptible representation,
the one or more material testing systems are further configured to send system data to the central server, the system data pertaining to information about the one or more material testing systems,
the central server processing circuitry is further configured to identify the particular material testing system based on a user selection, and determine particular system data relevant to the particular material testing system based on the system data, the test data, and the particular material testing system, and
the user interface is configured to receive the user selection as an input, and output a second human perceptible representation of the particular system data, and optionally
wherein the particular system data comprises a system identifier of the particular material testing system, a current testing status of the particular material testing system, a current tester of the particular material testing system, event information relating to one or more events pertaining to the particular material testing system, a machine identifier of a particular material testing machine of the particular material testing system, a date of manufacture of the particular material testing machine, a description of the particular material testing machine, sensor information relating to one or more sensors of the particular material testing machine, calibration information relating to a calibration of the one or more sensors or the particular material testing machine, a workstation identifier of a particular testing workstation of the particular material testing system, or software information relating to a software running on the particular testing workstation.

9. The system of any one of claims 6 to 8, wherein:
the plurality of material testing systems are further configured to send system data to the central server, the system data comprising error data indicating that a sensor or other machine component of a particular material testing machine of the particular material testing system has had a malfunction, and
the central server processing circuitry is further configured to:
determine, based on the error data, whether the malfunction warrants servicing of the sensor or the particular material testing machine,
in response to determining the malfunction does warrant servicing of the sensor or the particular material testing machine, output a query, via the user interface, as to whether a service visit should be scheduled, and
in response to receiving a positive response to the query, via the user interface, communicate with a service center to schedule the service visit.

10. The system of claim 9, wherein the central server processing circuitry is further configured to:
identify one or more qualified service technicians based on the malfunction, the error data, the type of sensor or other machine component, the test data, or a service history, and
output, via the user interface, a list identifying the one or more qualified service technicians, and optionally
wherein the user interface is configured to receive a selection of a particular service technician from the list identifying the one or more qualified service technicians, the central server processing circuitry is configured to identify the service center of the particular service technician, and the central server is configured to communicate with the service center to schedule the service visit.

11. A method, comprising:
receiving, at a central server, test data from one or more material testing systems, the test data relating to testers, test parameters, test results, or test timings of a plurality of tests conducted using the one or more material testing systems;
determining, at the central server, a utilization metric based on the test data, the utilization metric indicating how much or how often a particular material testing system, or the one or more material testing systems were used for testing during a selected time period; and
outputting, via a user interface, a human perceptible representation of the utilization metric.

12. The method of claim 11, wherein the utilization metric comprises (i) a number of tests performed by one or more testers, the particular material testing system, or the one or more material testing systems, during the selected time period, (ii) an amount of samples or specimens tested by the one or more testers, the particular material testing system, or the one or more material testing systems, during the selected time period, or (iii) a fraction or percentage of the one or more testers, or the one or more material testing systems, that were performing a test at particular times during the selected time period.

13. The method of claim 11 or claim 12, wherein the human perceptible representation comprises a first human perceptible representation, the method further comprising:
receiving, at the central server, system data from the one or more material testing systems, the system data pertaining to information about the one or more material testing systems;
identifying, via the central server, the particular material testing system based on a user selection received via the user interface;
determining particular system data relevant to the particular material testing system based on the system data, the test data, and the particular material testing system; and
outputting, via the user interface, a second human perceptible representation of the particular system data, and optionally
wherein the particular system data comprises a system identifier of the particular material testing system, a current testing status of the particular material testing system, a current tester of the particular material testing system, event information relating to one or more events pertaining to the particular material testing system, a machine identifier of a particular material testing machine of the particular material testing system, a date of manufacture of the particular material testing machine, a description of the particular material testing machine, sensor information relating to one or more sensors of the particular material testing machine, calibration information relating to a calibration of the one or more sensors or the particular material testing machine, a workstation identifier of a particular testing workstation of the particular material testing system, or software information relating to a software running on the particular testing workstation.

14. The method of any one of claims 11 to 13, further comprising:
receiving, at the central server, system data from a particular material testing system of the one or more material testing systems, the system data comprising error data indicating that a sensor or other machine component of a particular material testing machine of the particular material testing system has had a malfunction;
determining, via the central server, based on the error data, whether the malfunction warrants servicing of the sensor or the particular material testing machine;
in response to determining the malfunction does warrant servicing of the sensor or the particular material testing machine, outputting a query, via the user interface, as to whether a service visit should be scheduled; and
in response to receiving a positive response to the query, communicating with a service center, via the central server, to schedule the service visit.

15. The method of claim 14, further comprising:
identifying one or more qualified service technicians based on the malfunction, the error data, the type of sensor or other machine component, the test data, or a service history; and
outputting, via the user interface, a list identifying the one or more qualified service technicians, wherein the central server communicates with the service center to schedule the service visit in response to receiving, via the user interface, a selection of a particular service technician and identifying the service center of the particular service technician.
